# EUROPEAN PATENT APPLICATION

(11) **EP 4 576 998 A1**
(43) Date of publication of application: **25.06.2025**
(21) Application number: 24220345.3
(22) Date of filing: 16.12.2024
(51) Int. Cl.: H10D 84/08, H10D 30/47, H10D 84/40, H10D 84/82

(54) **SEMICONDUCTOR DEVICE WITH MULTIPLE DEVICE REGIONS AND METHOD OF FABRICATION THEREFOR**

(30) Priority: 19.12.2023 US 202318545492
(71) Applicant: NXP USA, Inc., Austin, TX 78735 (US)
(72) Inventor: Wan, Jianwei, 5656AG Eindhoven (NL); Green, Bruce McRae, 5656AG Eindhoven (NL); Kirchgessner, James Albert, 5656AG Eindhoven (NL)
(74) Representative: Hardingham, Christopher Mark

(57) **Abstract**

A semiconductor device includes a silicon (Si) base substrate (101) having a first crystal orientation, a first device region (120) formed over the Si base substrate, wherein the first device region includes a gallium nitride (GaN) layer formed over the Si base substrate and a transition layer (104) having a second crystal orientation disposed between the GaN layer and the Si base substrate. First and second current-carrying electrodes (132, 134) are formed over the GaN layer in a first active area with a first control electrode (136) between the first and second current-carrying electrodes. A second device region (150, 170) is formed laterally adjacent the first device region, wherein the second device region includes a second Si layer formed over the Si base substrate. Third and fourth current-carrying electrodes are formed over the second Si layer in a second active area with a second control electrode formed between the third and fourth current-carrying electrodes.

## Description

### TECHNICAL FIELD

Embodiments of the subject matter described herein relate generally to semiconductor devices and methods for fabricating such devices.

### BACKGROUND

Semiconductor devices find application in a wide variety of electronic components and systems. High power, high frequency transistors find application in radio frequency (RF) systems and power electronics systems. Gallium nitride (GaN) device technology is particularly suited for these RF power and power electronics applications due to its superior electronic and thermal characteristics. In particular, the high electron velocity and high breakdown field strength of GaN make devices fabricated from this material ideal for RF power amplifiers and high-power switching applications. At the same time, other technologies such as silicon metal oxide field effect transistor (Si MOSFET) technology and silicon germanium (SiGe) bipolar technology have increased integration capability compared to GaN device technology. Accordingly, there is a need for semiconductor devices that combine GaN device technology with Si MOSFET's and SiGe HBT technologies.

### BRIEF DESCRIPTION OF THE DRAWINGS

A more complete understanding of the subject matter may be derived by referring to the detailed description and claims when considered in conjunction with the following figures, wherein like reference numbers refer to similar elements throughout the figures.
FIG. 1 is a cross-sectional, side view of an exemplary semiconductor device, in accordance with an embodiment; and
FIGs 2-5 are cross-sectional, side views of an exemplary semiconductor device displayed alongside process steps, both describing a method for fabricating the semiconductor device of FIG. 1, in accordance with an embodiment.

### SUMMARY

In one aspect, an embodiment may include a semiconductor device that includes a silicon (Si) base substrate having a first crystal orientation, a first device region formed over the Si base substrate, wherein the first device region includes a gallium nitride (GaN) layer formed over the Si base substrate and a transition layer having a second crystal orientation is disposed between the GaN layer and the Si base substrate. A first active area may be formed in the GaN layer. First and second current-carrying electrodes may be formed over the GaN layer, electrically coupled to the first active area, and configured to support a current flow within the first active area. A first control electrode may be formed over the GaN layer, electrically coupled to the first active area, and configured to control the current flow between the first and second current-carrying electrodes. A second device region may be formed laterally adjacent the first device region, wherein the second device region may include a first Si layer formed over the Si base substrate, third and fourth current-carrying electrodes formed over the Si layer and configured to support a current flow within a second active area of the second device region. A second control electrode may be formed over the Si layer and electrically coupled to the second device region and configured to control the current flow between the third and fourth current-carrying electrodes.

In an embodiment, the first crystal orientation may be (1 0 0) and the second crystal orientation may be (1 1 1).

An embodiment may include a bonding layer formed between the transition layer and the Si base substrate.

The bonding layer may include a buried oxide layer, according to an embodiment.

In an embodiment, the transition layer may include a material selected from the group consisting of silicon, silicon carbide, gallium nitride, and aluminum nitride.

An embodiment may include a passivation dielectric region formed between a first sidewall of the first device region and a second sidewall of the second device region.

The passivation dielectric region may include silicon nitride, according to an embodiment.

In an embodiment, a first upper surface of the first device region and a second upper surface of the second device region may be co-planar.

In an embodiment, the first current-carrying electrode may be configured as a first source electrode, the second current-carrying electrode may be configured as a first drain electrode, and the first control electrode may be configured as a first gate electrode.

In an embodiment, the third current-carrying electrode may be configured as an element selected from the group consisting of a source electrode and an emitter electrode, the fourth current-carrying electrode may be configured as an element selected from the group consisting of a drain electrode and a collector electrode, and the second control electrode may be configured as an element selected from the group consisting of a gate electrode and a base electrode.

An embodiment may include a third device region formed laterally adjacent the first device region, wherein the third device region may include a second Si layer formed over the Si base substrate a fifth current-carrying electrode and a sixth current-carrying electrode formed over the second Si layer, electrically coupled to a third active area, and configured to support a current flow within the third device region, and a third control electrode formed over the second Si layer, electrically coupled to the third active area, and configured to control the current flow between the fifth and sixth current-carrying electrodes.

In an embodiment, the first current-carrying electrode may be configured as a first source electrode, the second current-carrying electrode may be configured as a first drain electrode, the first control electrode may be configured as a first gate electrode, the third current-carrying electrode may be configured as an element selected from the group consisting of a source electrode and an emitter electrode, the fourth current-carrying electrode may be configured as an element selected from the group consisting of a drain electrode and a collector electrode, the second control electrode may be configured as an element selected from the group consisting of a gate electrode and a base electrode, the fifth current-carrying electrode may be configured as an element selected from the group consisting of a source electrode and an emitter electrode, the sixth current-carrying electrode may be configured as an element selected from the group consisting of a drain electrode and a collector electrode; and the third control electrode may be configured as an element selected from the group consisting of a gate electrode and a base electrode.

In another aspect, an embodiment may include a method for forming a semiconductor device. In an embodiment, the method may include forming a bonding layer over a Si base substrate having a first crystal orientation and forming a transition layer having a second crystal orientation over the bonding layer. The method may further include forming a gallium nitride (GaN) layer over the transition layer, according to an embodiment. The method may further include etching a first portion of the GaN layer, exposing a first surface of the Si base substrate, and forming a first device region that includes the GaN layer having a first sidewall at a first edge of the GaN layer and a second device region over the first surface of the Si base substrate, according to an embodiment. In an embodiment, the method may include forming first and second current-carrying electrodes over the GaN layer in the first device region and forming a first control electrode over the GaN layer in the first device region. The method may further include forming a first Si layer over the Si base substrate in the second device region, according to an embodiment. An embodiment of the method may include forming third and fourth current-carrying electrodes over the Si layer in the second device region and forming a second control electrode formed over the Si layer in the second device region.

In an embodiment, the method may include forming a passivation dielectric region over the GaN layer.

In an embodiment of the method, the first crystal orientation may be (1 0 0) and the second crystal orientation may be (1 1 1).

In an embodiment of the method, forming the bonding layer may include forming a buried oxide layer.

The method may further include forming a passivation dielectric region between the first sidewall of the first device region and a second sidewall of the second device region, according to an embodiment.

In an embodiment of the method, forming the passivation dielectric region may include depositing silicon nitride.

In an embodiment of the method, forming the first current-carrying electrode may include forming a first source electrode, forming the second current-carrying electrode may include forming a first drain electrode, and forming the first control electrode may include forming a first gate electrode.

In an embodiment of the method, forming the third current-carrying electrode may include forming an element selected from the group consisting of a source electrode and an emitter electrode, forming the fourth current-carrying electrode may include forming an element selected from the group consisting of a drain electrode and a collector electrode, and forming the second control electrode may include forming an element selected from the group consisting of a gate electrode and a base electrode.

An embodiment of the method may include forming a third device region laterally adjacent the first device region, wherein forming the third device region may include forming a second Si layer over the Si base substrate, forming a fifth current-carrying electrode, and forming a sixth current-carrying electrode over the second Si layer, and forming a third control electrode formed over the second Si layer.

In an embodiment of the method, forming the first current-carrying electrode may include forming a first source electrode, forming the second current-carrying electrode may include forming a first drain electrode, forming the first control electrode may include forming a first gate electrode, forming the third current-carrying electrode may include forming an element selected from the group consisting of a source electrode and an emitter electrode, forming the fourth current-carrying electrode may include forming an element selected from the group consisting of a drain electrode and a collector electrode, forming the second control electrode may include forming an element selected from the group consisting of a gate electrode and a base electrode, forming the fifth current-carrying electrode may include forming an element selected from the group consisting of a source electrode and an emitter electrode, forming the sixth current-carrying electrode may include forming an element selected from the group consisting of a drain electrode and a collector electrode, and forming the third control electrode may include forming an element selected from the group consisting of a gate electrode and a base electrode.

### DETAILED DESCRIPTION

The following detailed description is merely illustrative in nature and is not intended to limit the embodiments of the subject matter or the application and uses of such embodiments. As used herein, the words "exemplary" and "example" mean "serving as an example, instance, or illustration." Any implementation described herein as exemplary, or an example is not necessarily to be construed as preferred or advantageous over other implementations. Furthermore, there is no intention to be bound by any expressed or implied theory presented in the preceding technical field, background, or the following detailed description.

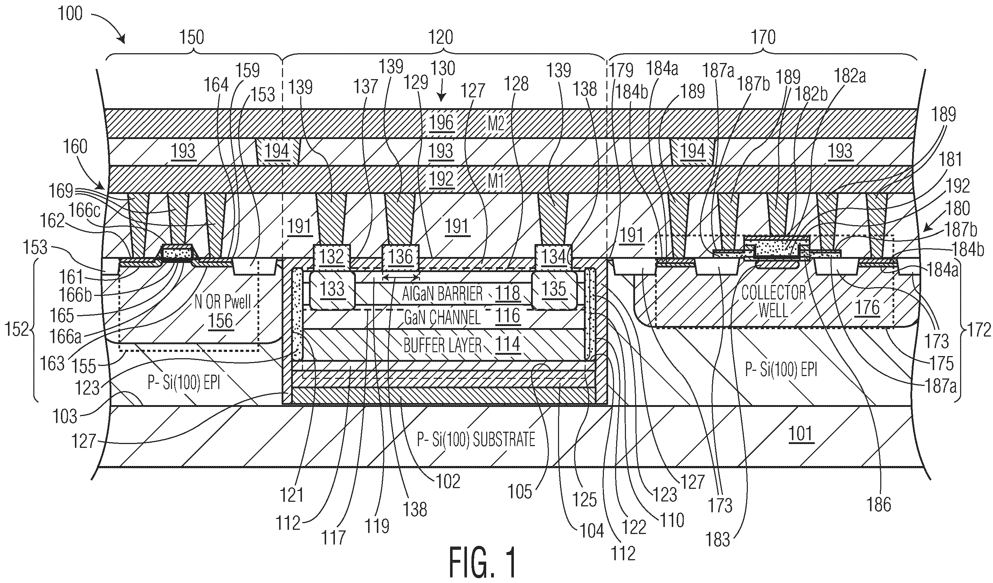

FIG. 1 is a cross-sectional, side view of an exemplary semiconductor device 100 in accordance with an embodiment. Semiconductor device 100 may include a silicon (Si) base substrate 101 having a first crystal orientation, a first device region 120, a second device region 150, and a third device region 170, wherein first, second, and third device regions 120, 150, and 170 are formed over the Si base substrate 101,

The first device region 120 includes GaN transistor 130 and may include one or more gallium nitride (GaN) epitaxial layers (i.e., "GaN layer") 110 formed over the Si base substrate 101, a bonding layer 102 disposed over the Si base substrate 101, a transition layer 104 disposed between the GaN epitaxial layers 110 and the Si base substrate 101. Silicon base substrate 101 may be formed from Si, Si on insulator (SOI) or other suitable material(s). In an embodiment, the Si base substrate 101 may have a first crystal orientation and the transition layer 104 may include a second crystal orientation. In an embodiment, the first crystal orientation may be (1 0 0) and the second crystal orientation may be (1 1 1). Thus, in some embodiments Si base substrate 101 may have a (1 0 0) crystal orientation useful for fabricating metal-oxide-semiconductor (MOS) devices and transition layer 104 may have a (1 1 1) crystal orientation that may be used as a surface on which to grow GaN epitaxial layers 110. The thickness of Si base substrate 101 may be between about 10 micrometers and about 2000 micrometers although other thicker or thinner thicknesses may be used, according to an embodiment. The transition layer 104 may be formed from Si and may have a thickness between about 10 nanometers and about 10,000 nanometers although other thicker or thinner thicknesses may be used, according to an embodiment. In other embodiments, other materials may be used instead of Si to form transition layer 104. In these other embodiments, silicon carbide (SiC), diamond, GaN, aluminum nitride (AlN), or other suitable materials may be used to form transition layer 104.

In an embodiment, a bonding layer 102 may be formed between transition layer 104 and the Si base substrate. In an embodiment, the bonding layer 102 may include a buried oxide (BOx) layer. In other embodiments the bonding layer 102 may include silicon nitride, silicon dioxide (SiO₂), aluminum oxide (Al₂O₃), or other suitable material(s). In some embodiments, the thickness of the BOx layer 102 may be between about 10 nanometers and about 50 nanometers. In other embodiments, the thickness of the bonding layer 102 may be between about 3 nanometers and about 1000 nanometers. Although other thicker or thinner thicknesses may be used, according to an embodiment.

In an embodiment, the GaN epitaxial layers 110 may include a buffer layer 114 disposed over transition layer 104, a channel layer 116 disposed over buffer layer 114, a barrier layer 118 disposed over channel layer 116, and a cap layer 119 disposed over barrier layer 118. A nucleation layer 112 may be formed on an upper surface 103 of base Si substrate 101 between the buffer layer 114 and the base Si substrate 101. In an embodiment, the nucleation layer may include AlN. The buffer layer 114 may include a number of group III-N semiconductor layers and is supported by the transition layer 104. Each of the semiconductor layers of the buffer layer 114 may include an epitaxially grown group III-nitride epitaxial layer. The group-III nitride epitaxial layers that make up the buffer layer 114 may be nitrogen (N)-face or gallium (Ga)-face material, for example. In other embodiments, the semiconductor layers of the buffer layer 114 may not be epitaxially grown. In still other embodiments, the semiconductor layers of the buffer layer 114 may include Si, GaAs, InP, or other suitable materials.

In an embodiment, the buffer layer 114 may be grown epitaxially over the nucleation layer 112. The buffer layer 114 may include at least one AlGaN mixed crystal layer having a composition denoted by AlxGai-xN with an aluminum mole fraction, X, that may take on values between 0 and 1. The total thickness of the buffer layer 114 with all of its layers may be between about 200 angstroms and about 100,000 angstroms although other thicknesses may be used. A limiting X value of 0 yields pure GaN while a value of 1 yields pure aluminum nitride (AlN). An embodiment may include a buffer layer 114 disposed over the host substrate and nucleation layer (not shown). The buffer layer 114 may include additional Al_{X}Ga_{1-X}N layers. The thickness of the additional Al_{X}Ga_{1-X}N layer(s) may be between about 200 angstroms and about 50,000 angstroms though other thicknesses may be used. In an embodiment, the additional Al_{X}Ga_{1-X}N layers may be configured as GaN (X=0) where the Al_{X}Ga_{1-X}N is not intentionally doped (NID). The additional Al_{X}Ga_{1-X}N layers may also be configured as one or more GaN layers where the one or more GaN layers are intentionally doped with dopants that may include iron (Fe), chromium (Cr), carbon I or other suitable dopants that render the buffer layer 114 substantially insulating or high resistivity. The dopant concentration may be between about 10¹⁷ cm⁻³ and 10¹⁹ cm⁻³ though other higher or lower concentrations may be used. The additional Al_{X}Ga_{1-X}N layers may be configured with X=0.01 to 0.10 where the Al_{X}Ga_{1-X}N is NID or, alternatively, where the Al_{X}Ga_{1-X}N is intentionally doped with Fe, Cr, C, or other suitable dopant species. In other embodiments (not shown), the additional layers may be configured as a superlattice where the additional layers include a series of alternating NID or doped Al_{X}Ga_{1-X}N layers where the value of X takes a value between 0 and 1. In still other embodiments, the buffer layer 114 may also include one or more indium gallium nitride (InGaN) layers, with composition denoted In_{Y}Ga_{1-Y}N, where Y, the indium mole fraction, may take a value between 0 and 1. The thickness of the InGaN layer(s) may be between about 50 angstroms and about 2,000 angstroms, though other thicknesses may be used.

In an embodiment, a channel layer 116 may be formed over the buffer layer 114. The channel layer 116 may include one or more group III-N semiconductor layers and may be supported by the buffer layer 114. The channel layer 116 may include an Al_{X}Ga_{1-X}N layer where X takes on values between 0 and 1. In an embodiment, the channel layer 116 is configured as GaN (X=0) although other values of X may be used without departing from the scope of the inventive subject matter. The thickness of the channel layer 116 may be between about 50 angstroms and about 10,000 angstroms though other thicknesses may be used. The channel layer 116 may be NID or, alternatively, may include Si, germanium (Ge), C, Fe, Cr, or other suitable dopants. The dopant concentration may be between about 10¹⁵ cm⁻³ and about 10¹⁹ cm⁻³ though other higher or lower concentrations may be used. In other embodiments, the channel layer 116 may include NID or doped In_{Y}Ga_{1-Y}N, where Y, the indium mole fraction, may take a value between 0 and 1.

A barrier layer 118 may be formed over the channel layer 116 in accordance with an embodiment. The barrier layer 118 may include one or more group III-N semiconductor layers and is supported by the channel layer 116. In some embodiments, the barrier layer 118 may have a larger bandgap and larger spontaneous polarization than the channel layer 116 and, when the barrier layer 118 is in direct contact with the channel layer 116, a channel 117 is created in the form of a two-dimensional electron gas (2-DEG) within the channel layer 116 near the interface between the channel layer 116 and barrier layer 118. In addition, strain between the barrier layer 118 and channel layer 116 may cause additional piezoelectric charge to be introduced into the 2-DEG and channel 117. The barrier layer 118 may include at least one NID Al_{X}Ga_{1-X}N layer where X takes on values between 0 and 1. In some embodiments, X may take a value of 0.1 to 0.35, although other values of X may be used. The thickness of the barrier layer 118 may be between about 50 angstroms and about 1000 angstroms though other thicknesses may be used. The barrier layer 118 may be NID or, alternatively, may include Si, Ge, C, Fe, Cr, or other suitable dopants. The dopant concentration may be between about 10¹⁶ cm⁻³ and 10¹⁹ cm⁻³ though other higher or lower concentrations may be used. In an embodiment, an additional AlN interbarrier layer (not shown) may be formed between the channel layer 116 and the barrier layer 118, according to an embodiment. The AlN interbarrier layer may increase the channel charge and improve the electron confinement of the resultant 2-DEG. In other embodiments, the barrier layer 118 may include indium aluminum nitride (InAlN) layers, denoted In_{Y}Al_{1-Y}N, where Y, the indium mole fraction, may take a value between about 0.1 and about 0.2 though other values of Y may be used. In the case of an InAlN barrier, the thickness of the barrier layer 118 may be between about 30 angstroms and about 1000 angstroms though other thicknesses may be used. In the case of using InAlN to form the barrier layer 118, the InAlN may be NID or, alternatively, may include Si, Ge, C, Fe, Cr, or other suitable dopants. The dopant concentration may be between about 10¹⁶ cm⁻³ and about 10¹⁹ cm⁻³ though other higher or lower concentrations may be used.

In an embodiment illustrated in FIG. 1, a cap layer 119 may be formed over the barrier layer 118. The cap layer 119 may present a stable surface for the GaN epitaxial layers 110 and may protect the surface of the GaN epitaxial layers 110 from chemical and environmental exposure incident to wafer processing. The cap layer 119 may include one or more group III-N semiconductor layers and is supported by the barrier layer 118. In an embodiment, the cap layer 119 is GaN. The thickness of the cap layer 119 may be between about 5 angstroms and about 100 angstroms though other thicknesses may be used. The cap layer 119 may be NID or, alternatively, may include Si, Ge, C, Fe, Cr, or other suitable dopants. The dopant concentration may be between about 10¹⁶ cm⁻³ and 10¹⁹ cm⁻³ though other higher or lower concentrations may be used. Without departing from the scope of the inventive subject matter, it should be appreciated that the choice of materials and arrangement of layers to form the GaN epitaxial layers 110 is exemplary. It should be appreciated that the inclusion of the nucleation layer 112, the buffer layer 114, the channel layer 116, the barrier layer 118, and the cap layer 119 into the GaN epitaxial layers 110 is exemplary and that the function and operation of the various layers may be combined and may change depending on the materials used in any specific embodiment. For example, in some embodiments, the cap layer 119 may be omitted (not shown). In other embodiments using N-polar materials, the channel layer 116 may be disposed over the barrier layer 118 to create a 2-DEG directly beneath the cap layer 119 and the gate electrode 136 (not shown).

In an embodiment, the first device region 120 may be formed by removing one or more of the epitaxial and/or other semiconductor layers of the GaN epitaxial layers 110, forming first and second sidewalls 121, 122, and then using ion implantation to damage and further enhance the semi-insulating properties of the remaining layers of the GaN epitaxial regions 110 and leaving behind first active region 125 "mesas" surrounded by high resistivity or semi-insulating isolation regions 123 that have been implanted. One or more isolation regions 123 may be formed in the GaN epitaxial layers 110 to partially define the first active region 125 above and along the upper surface 105 of transition layer 104, according to an embodiment. The isolation regions 123 may be formed via an implantation procedure configured to damage the epitaxial and/or other semiconductor, rendering the GaN epitaxial layers 110 high resistivity or semi-insulating in those isolation regions 123 while leaving the crystal structure intact in the first active region 125. In other embodiments, isolation regions 123 may be omitted and may use only the etching of GaN epitaxial layers 110 to define first active region 125.

In an embodiment, a passivation dielectric region 127 may encapsulate first device region 120 and may be formed between a first and second sidewalls 121, 122 of the first device region 120 and first and second Si layers 152, 172 of second and third device regions 150, 170.

In an embodiment, the passivation dielectric region 127 may include one or more layers of silicon nitride (SiN). In other embodiments, the passivation dielectric region 127 may be formed from one or more suitable materials including silicon dioxide (SiO₂), silicon oxynitride (SiON), aluminum oxide (Al₂O₃), aluminum nitride (AlN), and hafnium oxide (HfO₂), though other substantially insulating materials may be used. In an embodiment, the passivation dielectric region 127 may have a thickness of between 200 angstroms and 1000 angstroms. In other embodiments, the passivation dielectric region 127 may have a thickness of between 50 angstroms and 10000 angstroms, though other thicknesses may be used.

In other embodiments, passivation dielectric region 127 may include silicon dioxide SiO₂, Al₂O₃, or other suitable materials with or without the one or more layers of SiN. In an embodiment, passivation dielectric region 127 may be between about 100 angstroms and about 2000 angstroms thick, although other thicker or thinner values may be used.

Source and drain electrodes 132, 134 (i.e., "first and second current-carrying electrodes" may be formed over the GaN epitaxial layers, electrically coupled to the channel 117 (i.e., "channel region"), and configured to support a current flow within the channel 117. A first gate electrode 136 (i.e., "first control electrode") may be formed over the GaN epitaxial layers 110, electrically coupled to the channel 117, and configured to control the current flow between the first and second current-carrying electrodes 132, 134.

In an embodiment, the source electrode 132 and the drain electrode 134 may be formed over and contact source and drain regions 133, 135 formed in GaN epitaxial layers 110 in the first active region 125. The source electrode 132 and the drain electrode 134 may be formed inside openings (e.g., opening 137) in the passivation dielectric region 127 and may be formed from one or more conductive layers. In some embodiments, ion implantation may be used to form ohmic contact to the channel 117 to create source and drain regions 133, 135. In an embodiment, the one or more conductive layers used to form source and drain electrodes 132, 134 may include titanium (Ti), gold (Au), Al, molybdenum (Mo), nickel (Ni), Si, Ge, platinum (Pt), tantalum (Ta), or other suitable materials. In other embodiments, the one or more conductive layers used to form source and drain electrodes 132, 134 may include titanium-tungsten (TiW), titanium-aluminum (TiAl), or titanium-tungsten nitride (TiWN). In an embodiment, the source electrode 132 and the drain electrode 134 may be formed over and in contact with the cap layer 119. In other embodiments (not shown), one or both of the source electrode 132 and the drain electrode 134 may be recessed through the cap layer 119 and extend partially through the barrier layer 118. In an embodiment, the source electrode 132 and the drain electrode 134 may be formed from a multi-layer stack. In an embodiment, the multi-layer stack used to form the source electrode 132 and the drain electrode 134 may include an adhesion layer and one or more layers (not shown), that when annealed, allows an ohmic contact to form between the channel 117 and the source and drain electrodes 132, 134. In an embodiment, the adhesion layer may include titanium (Ti), tantalum (Ta), silicon (Si), or other suitable materials. In an embodiment, the adhesion layer may have a work function that is below 4.5 electron-volts.

First gate electrode 136 may be formed over the GaN epitaxial layers 110, electrically coupled to the channel 117, and configured to control the current flow between the first and second current-carrying electrodes. In an embodiment, the first gate electrode 136 may be characterized by a gate length 138. In an embodiment, the gate length 138 may be between about 0.05 microns and about 1 micron. In other embodiments, the gate length 138 may be between about 0.02 microns and about 5 microns, though other suitable dimensions may be used.

Changes to the electric potential applied to the first gate electrode 136 may shift the quasi-Fermi level for the barrier layer 118 with respect to the quasi-Fermi level for the channel layer 116 and thereby modulate the electron concentration in the channel 117 within the GaN epitaxial layers 110 under the first gate electrode 136. One or more Schottky materials such as Ni, palladium (Pd), Pt, iridium (Ir), or Copper (Cu), may be combined with one or more of low stress conductive materials such as Au, Al, Cu, poly Si, or other suitable material(s) in a metal stack to form a first gate electrode 136 for a low-loss, first gate electrode 136 electrically coupled to channel 117, according to an embodiment.

Still referring to FIG. 1, second device region 150 may be formed laterally adjacent the first device region 120 (e.g., using selective growth, well known to those with skill in the art, as described hereafter), according to an embodiment. The second device region 150 may include Si MOSFET device 160 and may include a first Si layer 152 formed over the Si base substrate 101, second source electrode 162 (i.e., "third current-carrying electrode") and second drain electrode 164 (i.e., "fourth current-carrying electrode") formed over the first Si layer 152 and may be configured to support a current flow within a second active area 155 of the second device region 150. A second gate electrode 166c (i.e., "control electrode") may be formed over the first Si layer 152 and electrically coupled to the second device region 152 and configured to control the current flow between the second source electrode 162 and second drain electrode 164. In an embodiment, a first upper surface 129 of the first device region 120, a second upper surface 159 of the second device region 150, and a third upper surface 179 of the third device region 170 may be co-planar.

In an embodiment, second device region 150 may be configured as a PMOS region or an NMOS region. First Si layer 152 may be formed using Si having the same crystal orientation as Si base substrate 101 (e.g. (1 0 0) orientation). In an embodiment, a n or p well (also referred to herein as "n/p well") 156 may be formed within first Si layer 152. In an embodiment, second source and second drain regions 161, 163 may be formed within n/p well 156. Channel region 165 may be formed laterally adjacent to and between second source and second drain regions 161, 163 and may include a n-type region for a PMOS device or a p-type region for an NMOS device. Second gate electrode 166a/b/c includes gate oxide 166a, gate poly 166b, and gate contact layer 166c, according to an embodiment. In an embodiment, gate dielectric 166a may include a gate oxide layer (e.g., SiO₂) formed over n/p well 156. Gate poly 166b may be formed over and contact gate oxide166a. Gate poly 166b may be formed using poly Si or other suitably conductive material, according to an embodiment. Gate contact layer 166c may be formed over or within gate poly layer 166b. Multiple NMOS or PMOS devices may be formed in multiple device areas similarly configured to second device region 150.

Referring still to FIG. 1, and in an embodiment, a third device region 170 may be formed laterally adjacent the first device region 120, wherein the third device 170 region may include a second Si layer 172 formed over the Si base substrate 101. In some embodiments, first and second Si layers 152, 172 may be formed simultaneously. In other embodiments, first and second Si layers 152, 172 may be formed separately. Emitter electrode 182b and collector electrode 184b (i.e., "fifth and sixth current-carrying electrodes") may be formed over the second Si layer 172, electrically coupled to the third device region 170, and configured to support a current flow within a third active area 175 of the third device region 170. A base electrode 187b (i.e., "third control electrode") may be formed over the second Si layer 152 and electrically coupled to the second active area 175 and may be configured to control the current flow between the emitter electrode 182b and the collector electrode 184b, according to an embodiment.

In an embodiment, semiconductor device 100 may be configured as a transistor finger wherein the first and second source electrodes 132, 162, the first and second drain electrodes 134, 164b, the first and second gate electrodes 136, 166a/b/c, emitter electrode 182b, collector electrode 184b, and base electrode 187b may be configured as elongated elements forming an active device finger. The semiconductor device 100 may be defined, in part, by isolation regions 123, 153, 173 in which a gate width of gate and/or emitter fingers (i.e., a dimension extending along an axis perpendicular to the plane of semiconductor device 100 of Figure 1 is significantly larger than the gate length 138 of the first gate electrode 136 (i.e., a dimension extending along an axis that is perpendicular to the width). In some embodiments, the gate width may be between about 50 microns and about 500 microns. In other embodiments, the gate width may be between about 1 microns and about 10,000 microns.

In other embodiments, additional dielectric and metal layers may be formed over semiconductor device 100. These additional dielectric and metal layers may include passivation layers, interconnect metallization, additional active devices, and additional circuitry, without limitation.

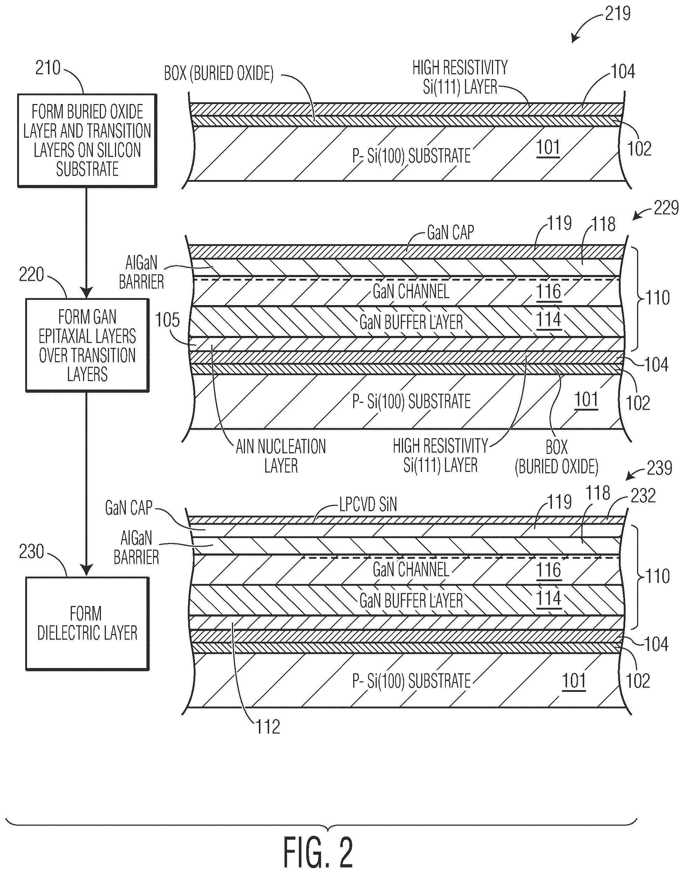

FIGs 2-5 describe embodiments of methods for fabricating embodiments of the semiconductor device of FIG. 1. FIGs 2-5 illustrate cross-sectional, side views of a series of fabrication steps alongside a flow chart describing the series of fabrication steps for producing the semiconductor devices of FIG. 1, in accordance with an example embodiment.

Referring now to FIG. 2, step 210, and, in an embodiment, the method may include forming a buried oxide (BOx) layer 102 (i.e., "bonding layer") over Si base substrate 101 having a first crystal orientation and forming a transition layer 104 having a second crystal orientation over the BOx layer 102. In an embodiment, BOx layer 102 may include materials selected from SiN, Al₂O₃, SiO₂, AlN, and HfO₂. BOx layer 102 may be formed using one or more of low pressure chemical vapor deposition (LPCVD), atomic layer deposition (ALD), sputtering, physical vapor deposition (PVD), plasma-enhanced vapor deposition (PECVD), metal-organic chemical vapor deposition (MOCVD), molecular beam epitaxy (MBE), inductively coupled plasma (ICP) deposition, electron-cyclotron resonance (ECR) deposition, or other suitable technique(s). In an embodiment of the method, the crystal orientation of the Si base substrate may be (1 0 0) (i.e., "first crystal orientation") and the crystal orientation of the transition layer 104 (i.e., "second crystal orientation") may be (1 1 1). In an embodiment, transition layer 104 may be formed by bonding a bonding wafer (e.g., Si, SiC, GaN, AlN) having the second crystal orientation (e.g., (1 1 1) crystal orientation for Si) to the BOx layer 102 using wafer bonding techniques (not shown), known to those with skill in the art. Using wafer separation techniques (not shown), well known to those with skill in the art, the bonding wafer may be pre-implanted with a damage layer placed at the thickness of the transition layer 104. The bonding wafer may then be annealed after bonding the Si bonding wafer to the BOx layer, causing the transition layer 104 to part from the remainder of the bonding wafer at the level of the damage layer so that only a portion of the bonding wafer that includes the transition layer 104 may remain. Structure 219 results.

Referring now to FIG. 2, step 220, the method may further include forming GaN epitaxial layers 110 (i.e., "GaN layer") over the transition layer 104, according to an embodiment. Forming GaN epitaxial layers 110 may include forming a number of semiconductor layers on or over the Si base substrate 101 and transition layer 104. Forming the semiconductor layers may include forming nucleation layer 112 on or over an upper surface 105 of transition layers 104, forming a buffer layer 114 on or over the nucleation layer 112, forming the channel layer 116 on or over the buffer layer 114, forming the barrier layer 118 on or over the channel layer 116, and forming the cap layer 119 on or over the barrier layer 118. As discussed previously, embodiments of the buffer layer 114, the channel layer 116, the barrier layer 118, and the cap layer 119 may include materials selected from AlN, GaN, AlGaN, InAlN, InGaN, or other suitable materials. The semiconductor layers 114, 116, 118, and 119 may be grown using one of metal-organo chemical vapor deposition (MOCVD), molecular beam epitaxy (MBE), hydride-vapor phase epitaxy (HVPE) or a combination of these techniques, although other suitable techniques may alternatively be used. Structure 229 results.

Referring now to step 230 of FIG. 2, an embodiment of the method may include forming dielectric layer 232 on or over the GaN epitaxial layers 110. In an embodiment, the dielectric layer 232 may include materials selected from SiN, Al2O3, SiO2, AlN, and HfO2. The dielectric layer 232 may be formed using one or more of LPCVD, ALD, sputtering, PVD, PECVD, MOCVD, MBE, ICP deposition, ECR deposition, or other suitable techniques. In other embodiments, dielectric layer 232 may be formed, in-situ, immediately after and in the same chamber or deposition system (e.g., MOCVD or MBE) as the growth of the semiconductor layers of GaN epitaxial layers 110. Structure 239 results.

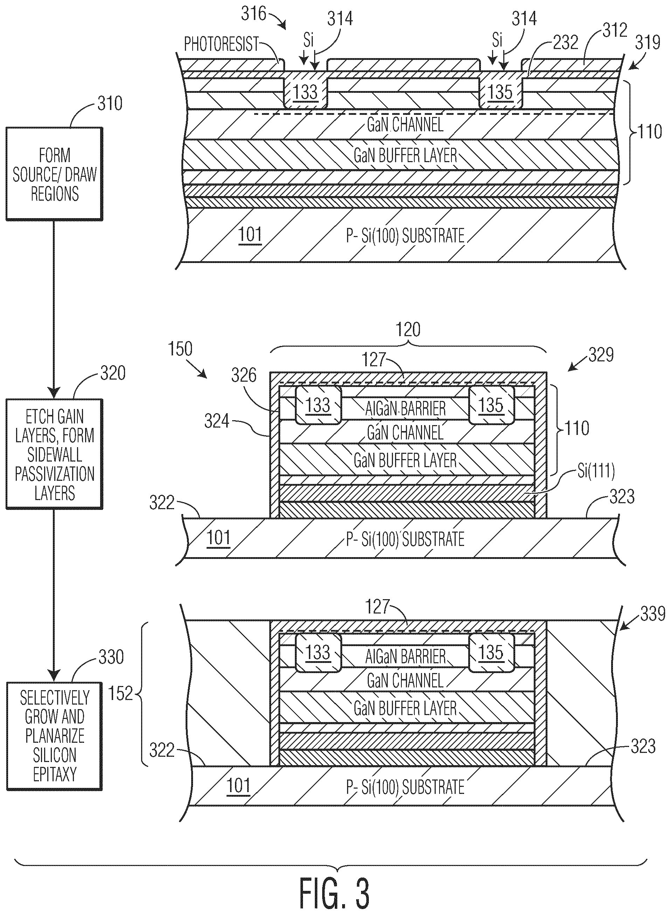

Referring now to step 310 of FIG. 3, an embodiment of the method may include forming source and drain regions 133, 135 to enable formation of first and second current-carrying electrodes 132, 134 over the GaN epitaxial layers 110 in the first device region 120. An embodiment of the method may include forming doped (e.g., ion-implanted) source and drain regions 133 and 135. In these embodiments, the dielectric layer 232 may be used as a sacrificial layer. An embodiment of the method may include patterning an implant mask 312 and implanting a dopant species 314 through an opening 316 in implant mask 312 into the GaN epitaxial layers 110 to form the source and drain regions 133, 135 within the GaN epitaxial layers 110. Once the implant mask 312 is patterned, the dopant species 314 may be implanted through dielectric layer 232 and into the GaN epitaxial layers 110. In an embodiment, one or more of Si, Ge, O, or other suitable n-type dopant(s) may be implanted into the GaN epitaxial layers 110 through the implant mask 312 form the source and drain regions 133, 135. An activation anneal at a temperature of between about 1000 degrees Celsius (°C) and about 1300 °C may be used to activate the implant. Structure 319 results.

Referring now to FIG. 3, step 320, an embodiment of the method may further include etching a first portion of the GaN epitaxial layers 110, exposing first and second surface 322, 323 of the Si base substrate 101 and forming a first device region 120 that includes the GaN epitaxial layers 110 having a first sidewall 324 at a first edge 326 of the GaN layer and a second device region over the first surface of the Si base substrate, according to an embodiment. In some embodiments, dielectric layer 232 may be stripped after activation anneal and after etching GaN epitaxial layers 110. Passivation dielectric region 127 may be formed over first and second side walls 121, 122 and first upper surface 128 of GaN epitaxial layers 110. In an embodiment, passivation dielectric region 127 may include materials selected from SiN, Al2O3, SiO2, AlN, and HfO2. Passivation dielectric region 127 may be formed using one or more of LPCVD, ALD, sputtering, PVD, PECVD, MOCVD, MBE, ICP deposition, ECR deposition, or other suitable techniques. Structure 329 results.

Referring now to FIG. 3, step 330, the method may further include forming first and second Si layers 152, 172 over the Si base substrate in the second device region by selectively growing first and second Si layers 152, 172 on first and second surfaces 322, 323 of Si base substrate 101, according to an embodiment. Forming first and second Si layers 152, 172 may include epitaxial growth of Si using the same crystal orientation (e.g., (1 0 0)) as the crystal orientation of the Si base substrate 101. Epitaxial growth of Si may be accomplished using CVD, MOCVD, or other suitable crystal growth technique. Following epitaxial growth of first and second Si layers 152, 172, first and second Si layers 152, 172 together with passivation dielectric region 127 may be planarized using chemical mechanical polishing (CMP) or other suitable technique. Structure 339 results.

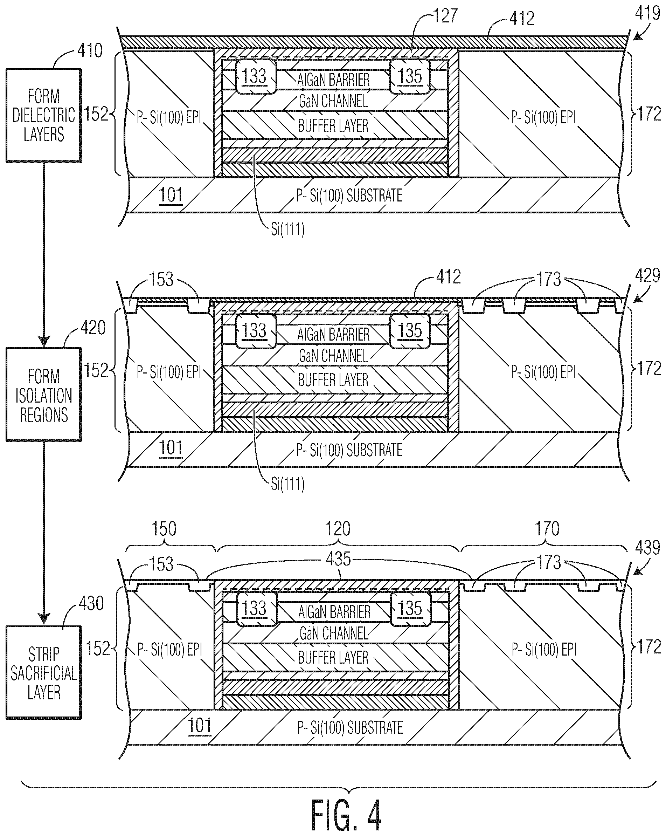

Referring now to FIG. 4, step 410, an embodiment of the method may include forming sacrificial layers 412 over passivation dielectric region 127 and first and second Si layers 152, 172. In an embodiment, sacrificial layers 412 may include materials selected from SiN, Al2O3, SiO2, AlN, and HfO2. Sacrificial layer 412 may be formed using one or more of LPCVD, ALD, sputtering, PVD, PECVD, MOCVD, MBE, ICP deposition, ECR deposition, or other suitable techniques. Structure 419 results.

Referring now to FIG. 4, step 420, an embodiment of the method may include forming isolation regions 153, 173 in first and second Si layers 152, 172 to form second and third device regions 150, 170. In an embodiment, isolation regions may be formed by etching (e.g., dry etching using F-based chemistry) first and second Si layers 152, 172 and backfilling with dielectric material (e.g., silicon dioxide). Etching may be accomplished using ICP, RIE, ECR dry etches, wet etches, or other suitable etching techniques. Backfill may be accomplished using LPCVD, PVD, PECVD, ICP deposition, ECR deposition, or other suitable techniques. A portion of sacrificial layer 412 remains over first and second Si layers 152, 172, and over passivation dielectric region 127. Structure 429 results.

Referring now to FIG. 4, step 430, an embodiment of the method may include stripping sacrificial layer 412 over first, second, and third device regions 120, 150, and 170. Etching may be accomplished using ICP, RIE, ECR dry etches, wet etches, or other suitable etching technique. Oxide regions within isolation regions 153, 173 remain. Structure 439 results.

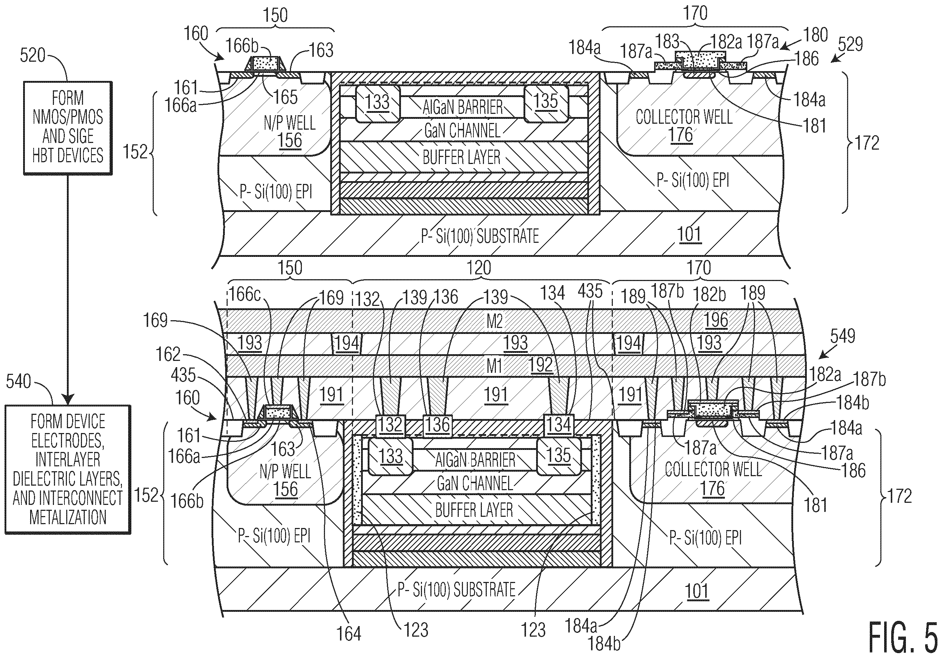

Referring now to FIG. 5, step 520, an embodiment of the method may include forming NMOS/PMOS devices 160 and/or SiGe HBT devices 180 in second and third device regions 150, 170. With the formation of isolation regions 153, 173 in first and second device regions 150, 170, NMOS/PMOS devices 160 and/or SiGe HBT devices 180 may be formed using techniques well-known to those with skill in the art.

In an embodiment, forming NMOS/PMOS devices 160 may include forming a n/p well 156 in first Si layer 152 and then forming second source and drain regions 161, 163 within n/p well 156 for making ohmic contact to n/p well 156. The method also may include forming channel region 165 and gate oxide 166a within and over n/p well 156. Gate poly material 166b may be formed over gate oxide 166a.

Referring still to FIG. 5, step 520, in an embodiment, forming SiGe HBT devices 180 may include forming a collector well 176 in second Si layer 172. The method also may include forming collector region 183 in collector well 176, forming collector contact regions 184a, forming base region 186 over collector region 183, forming extrinsic base regions 187a over collector well 176, forming intrinsic emitter region 181 over base region 186, and forming extrinsic emitter region 182a over intrinsic emitter region 181, according to an embodiment. Forming collector well 176, collector region 183, collector contact regions 184a, base region 186, extrinsic base regions 187a, and intrinsic emitter region 181, may be accomplished using techniques (e.g., patterning, diffusion, implantation, etching, etc.) known to those having skill in the art. Structure 529 results.

Referring now to FIG. 5, step 540, an embodiment of the method may include forming first source and drain electrodes 132, 134 (i.e., "first and second current carrying electrode) and first gate electrode 136 (i.e., "first control electrode") in first device region 120 over the GaN epitaxial layers 110. First source and drain electrodes 132, 134 may be formed by patterning and forming openings in passivation dielectric region 127 by etching (e.g., dry etching of SiN by ICP or RIE using F-based chemistry, e.g., SF₆ or other suitable chemistries) and depositing ohmic contact metal and patterning the ohmic contact metal (e.g. Ti/Al or other suitable metal(s)) over source and drain regions 133 and 135 using suitable techniques (e.g., PVD and dry etching). In an embodiment, first gate electrode 136 may be formed by patterning an opening in passivation dielectric region 127 (e.g., by dry etching SiN) and then by depositing (e.g., using PVD) and patterning gate metal (e.g., using dry etching).

Still referring to FIG. 5, step 540, In an embodiment, the method may further include forming second source and second drain electrodes 162, 164 (i.e., "third and fourth current-carrying electrodes") and forming second gate electrode 166a/b/c (i.e., "second control electrode") over gate poly material 166b over the first Si layer 152 in the second device region 150.

Still referring to FIG. 5, step 540, in an embodiment, the method may include forming collector electrodes 184b (i.e., "fourth current-carrying electrode" or "sixth current-carrying electrode") over collector contact regions 184a, forming base electrodes 186b (i.e., "second control electrode" or "third control electrode") over extrinsic base regions 187a, and forming emitter electrodes 182b (i.e., "third current-carrying electrode" or "fifth current-carrying electrode") over extrinsic emitter region 182b in the third device region 170. Forming collector electrodes 184b, base electrodes 186b, and emitter electrodes 182b may be accomplished using techniques (e.g., patterning, conductor deposition (e.g., silicide formation), etching, etc.) known to those having skill in the art.

Still referring to FIG. 5, step 540, an embodiment of the method may include depositing and patterning first and second interlayer dielectric (ILD) layers 191, 193 and first and second metal layers 192, 196 over first, second, and third device regions 120, 150, and 170, according to an embodiment. In an embodiment, first ILD layer 191 may be deposited over device surface 435, according to an embodiment. In an embodiment, first ILD layer 191 may be formed from SiO, TEOS, SiN or other suitable material using CVD, PECVD, PVD or other suitable deposition technique. In some embodiments, it may be desirable to use low stress films (i.e., films with stress less than 100 mega pascals) to realize first ILD layer 191. Device connection vias 139, 169, 189 may be formed in first ILD layer 191 with connections to first metal layer 192 using techniques (e.g., tungsten fill and planarization) known to those with skill in the art. First vias 194 and second metal layers 196 may be formed using techniques (e.g., tungsten or Cu damascene-filled vias and Al or Cu damascene metal layers), known to those with skill in the art. Structure 549 results. Additional processing (not shown) may include additional dielectric layers, via, metal layers, openings, and bond pads for external connections, according to an embodiment.

While at least one exemplary embodiment has been presented in the foregoing detailed description, it should be appreciated that a vast number of variations exist. It should also be appreciated that the exemplary embodiment or embodiments described herein are not intended to limit the scope, applicability, or configuration of the claimed subject matter in any way. Rather, the foregoing detailed description will provide those skilled in the art with a convenient road map for implementing the described embodiment or embodiments. It should be understood that various changes can be made in the function and arrangement of elements without departing from the scope defined by the claims, which includes known equivalents and foreseeable equivalents at the time of filing this patent application.

For the sake of brevity, conventional semiconductor fabrication techniques may not be described in detail herein. In addition, certain terminology may also be used herein for reference only, and thus are not intended to be limiting, and the terms "first," "second" and other such numerical terms referring to structures do not imply a sequence or order unless clearly indicated by the context.

The foregoing description refers to elements or nodes or features being "connected" or "coupled" together. As used herein, unless expressly stated otherwise, "connected" means that one element is directly joined to (or directly communicates with) another element, and not necessarily mechanically. Likewise, unless expressly stated otherwise, "coupled" means that one element is directly or indirectly joined to (or directly or indirectly communicates with) another element, and not necessarily mechanically. Thus, although the schematic shown in the figures depict one exemplary arrangement of elements, additional intervening elements, devices, features, or components may be present in an embodiment of the depicted subject matter.

## Claims

1. A semiconductor device comprising:
a silicon, Si, base substrate having a first crystal orientation;
a first device region formed over the Si base substrate, wherein the first device region comprises:
a gallium nitride (GaN) layer formed over the Si base substrate;
a transition layer having a second crystal orientation disposed between the GaN layer and the Si base substrate;
a channel region formed in the GaN layer;
first and second current-carrying electrodes formed over the GaN layer, electrically coupled to a first active area, and configured to support a current flow within the first active area; and
a first control electrode formed over the GaN layer, electrically coupled to the first active area, and configured to control the current flow between the first and second current-carrying electrodes;
a second device region formed laterally adjacent the first device region, wherein the second device region comprises:
a first Si layer formed over the Si base substrate;
third and fourth current-carrying electrodes formed over the first Si layer, and configured to support a current flow within an active area of the second device region; and
a second control electrode formed over the first Si layer, electrically coupled to the second device region, and configured to control the current flow between the third and fourth current-carrying electrodes.

2. The semiconductor device of claim 1, wherein the first crystal orientation is (1 0 0) and the second crystal orientation is (1 1 1).

3. The semiconductor device of claim 1 or 2, further comprising a bonding layer formed between the transition layer and the Si base substrate.

4. The semiconductor device of claim 3, wherein the bonding layer includes a buried oxide layer.

5. The semiconductor device of any preceding claim, wherein the transition layer includes a material selected from the group consisting of silicon, silicon carbide, gallium nitride, and aluminum nitride.

6. The semiconductor device of any preceding claim, further comprising a passivation dielectric region formed between a first sidewall of the first device region and a second sidewall of the second device region.

7. The semiconductor device of any preceding claim, wherein a first upper surface of the first device region and a second upper surface of the second device region are co-planar.

8. The semiconductor device of any preceding claim, wherein:
the first current-carrying electrode is configured as a first source electrode;
the second current-carrying electrode is configured as a first drain electrode; and
the first control electrode is configured as a first gate electrode.

9. The semiconductor device of claim 8, wherein:
the third current-carrying electrode is configured as an element selected from the group consisting of a source electrode and an emitter electrode;
the fourth current-carrying electrode is configured as an element selected from the group consisting of a drain electrode and a collector electrode; and
the second control electrode is configured as an element selected from the group consisting of a gate electrode and a base electrode.

10. The semiconductor device of any preceding claim, further comprising a third device region formed laterally adjacent the first device region, wherein the third device region comprises:
a second Si layer formed over the Si base substrate;
a fifth current-carrying electrode and a sixth current-carrying electrode formed over the second Si layer, electrically coupled to a third active area, and configured to support a current flow within the third device region; and
a third control electrode formed over the second Si layer, electrically coupled to the third active area, and configured to control the current flow between the fifth and sixth current-carrying electrodes.

11. The semiconductor device of claim 11, wherein:
the first current-carrying electrode is configured as a first source electrode;
the second current-carrying electrode is configured as a first drain electrode;
the first control electrode is configured as a first gate electrode;
the third current-carrying electrode is configured as an element selected from the group consisting of a source electrode and an emitter electrode;
the fourth current-carrying electrode is configured as an element selected from the group consisting of a drain electrode; and a collector electrode;
the second control electrode is configured as an element selected from the group consisting of a gate electrode and a base electrode;
the fifth current-carrying electrode is configured as an element selected from the group consisting of a source electrode and an emitter electrode;
the sixth current-carrying electrode is configured as an element selected from the group consisting of a drain electrode and a collector electrode; and
the third control electrode is configured as an element selected from the group consisting of a gate electrode and a base electrode.

12. A method for forming a semiconductor device, the method comprising:
forming a bonding layer over a Si base substrate having a first crystal orientation;
forming a transition layer having a second crystal orientation over the bonding layer;
forming a gallium nitride, GaN layer over the transition layer;
etching a first portion of the GaN layer, exposing a first surface of the Si base substrate, and forming a first device region that includes the GaN layer having a first sidewall at a first edge of the GaN layer and a second device region over the first surface of the Si base substrate;
forming first and second current-carrying electrodes over the GaN layer in the first device region;
forming a first control electrode over the GaN layer in the first device region;
forming a first Si layer over the Si base substrate in the second device region;
forming third and fourth current-carrying electrodes over the Si layer in the second device region; and
forming a second control electrode formed over the Si layer in the second device region.

13. The method of claim 12, further comprising forming a passivation dielectric region over the GaN layer.

14. The method of claim 12 or 13, wherein the first crystal orientation is (1 0 0) and the second crystal orientation is (1 1 1).

15. The method of any of claims 12 to 14, wherein forming the bonding layer includes forming a buried oxide layer.
